Europäisches Patentamt

European Patent Office

Office européen des brevets

(19)

(11) Publication number: **0 123 153**
A2

(12) **EUROPEAN PATENT APPLICATION**

(21) Application number: **84103250.1**

(22) Date of filing: **23.03.84**

(51) Int. Cl.³: **G 03 F 7/26**

(30) Priority: **24.03.83 JP 49309/83**

(43) Date of publication of application:
**31.10.84 Bulletin 84/44**

(84) Designated Contracting States:
**DE FR GB**

(71) Applicant: **FUJI PHOTO FILM CO., LTD.**
**210 Nakanuma Minamiashigara-shi**
**Kanagawa-ken(JP)**

(72) Inventor: **Yamasue, Kotaro c/o Fuji Photo Film Co., Ltd.**
**No. 4000 Kawajiri**
**Yoshida-cho Haibara-gun Shizuoka(JP)**

(72) Inventor: **Nishimura, Yoshiharu c/o Fuji Photo Film Co., Ltd.**
**No. 4000 Kawajiri**
**Yoshida-cho Haibara-gun Shizuoka(JP)**

(74) Representative: **Weinhold, Peter, Dr. et al,**
**Patentanwälte Dr. V. Schmied-Kowarzik Dipl.-Ing. G.**
**Dannenberg Dr. P. Weinhold Dr. D. Gudel Dipl.-Ing. S.**
**Schubert Dr. P. Barz Siegfriedstrasse 8**
**D-8000 München 40(DE)**

(54) Plate making process using positive working presensitized plate.

(57) A plate-making process for easy elimination of unnecessary image parts from a positive working presensitized plate, which includes the steps of, in sequence, exposing a positive working presensitized plate to active rays through a positive transparency, irradiating desired-to-be-exposed but unexposed parts of the presensitized plate with active rays conducted by an optical fiber, and developing the thus optically exposed presensitized plate; or which includes the steps of, in sequence, exposing a positive working presensitized plate to active rays through an original transparency, developing the photo-exposed presensitized plate, irradiating unnecessary image parts of the developed presensitized plate with active rays conducted by an optical fiber, and developing the resulting plate again.

## PLATE MAKING PROCESS USING
## POSITIVE WORKING PRESENSITIZED PLATE

The present invention relates to a process for making a printing plate using a positive working presensitized plate (which is abbreviated as positive "PS plate" hereinafter) and more particularly, to a plate-making process which enables retouching of unnecessary image parts by a simple and easy process.

In case of making a lithographic printing plate using a positive PS plate, there has been used a process in which a positive transparent original is brought into close contact with the surface of a light-sensitive layer by means of a vacuum printing frame, followed by exposure to active rays (imagewise exposure). The thus photoexposed PS plate is then treated with a developing solution, and subsequent thereto, washed with water. A deletion liquid is applied to unnecessary parts (such as those attributable to dust which adhered to the transparent original and the glass of the vacuum printing frame, film edges, register marks, etc.) of the thus produced image with a writing brush or the like; and then, the plate is washed with water to effect deletion, followed by coating

- 1 -

the processed surface of the PS plate with desensitizing gum. As for the deletion liquid, a strong alkaline solution, a deletion liquid having added thereto an organic solvent, a deletion liquid having added thereto a fluorine compound, or so on has been employed. However, these deletion liquids have their respective disadvantages and also suffer from defects common to all of them. That is, an alkaline solution damages a writing brush used for applying it, and the deletion liquid containing an organic solvent or a fluorine compound tend to eliminate the necessary image parts by their flowing and spreading, or by vapors of volatile ingredients contained therein. Further, using those deletion liquids is responsible for marked decrease of working efficiency in the plate-making process because of the problems presented in washing the applied deletion liquid away with water and for coating the plate surface with desensitizing gum in order to protect it from adhesion of stain.

Therefore, an object of the present invention is to provide a lithographic plate-making process using a positive presensitized plate which enables easy elimination of unnecessary image parts.

Another object of the present invention is to provide a lithographic plate-making process using a positive presensitized plate which enables elimination of desired-to-be-exposed but initially unexposed image parts by employing a simple and easy method without deletion liquids.

Other objects of this invention will be apparent to the skilled artisan from the detailed description hereinafter.

In general, the present invention involves using an optical fiber to transmit active rays to areas which should have been exposed during imagewise exposure, but were not due to dust or the like.

In one embodiment of the invention, the above-described objects are obtained by a process which comprises imagewise exposing through a positive transparent original a presensitized plate including a light-sensitive composition providing a visible contrast, after imagewise exposure, between exposed and unexposed portions, detecting unnecessary image parts (which correspond to unexposed parts upon the imagewise exposure), exposing the detected unnecessary image parts to active rays conducted by an optical fiber and then, developing the resulting presensitized plate (this process is called "process 1" hereinafter).

In a preferred embodiment of process 1, a print-out material is included in the light-sensitive composition to improve, upon imagewise exposure, the contrast between the exposed and unexposed parts.

- 3 -

In a second embodiment of the invention, the process comprises, in sequence, exposing as above the positive PS plate to active rays through an imagewise pattern, developing the photoexposed PS plate, irradiating the unnecessary image parts with active rays conducted by an optical fiber, and developing the resulting plate again (this process is called "process 2", hereinafter).

In a preferred embodiment of process 2, the light-sensitive composition contains a dye to provide a sharp demarcation between the image part and the non-image part after development.

The plate-making process of the present invention will now be described in detail below and in general involves use of a presensitized printing plate of the type in which development (and washing where needed) removes exposed portions to provide a positive image of unexposed portions on the surface of the plate.

A positive PS plate which can be employed in the present invention includes those which have a positive working light-sensitive layer on a hydrophilic surface of a support. As examples of a support having a hydrophilic surface, mention may be made of various kinds of materials which have been usable up to now as a support for a lithographic printing plate. Among those materials, an aluminium plate is especially useful. Examples of aluminium plates suitable to the support include not only pure aluminium and aluminium alloy plates, but also aluminium-laminated or aluminium-evaporated plastic films. It is preferable to subject such an aluminium plate to some surface treatment prior to coating the light-sensitive layer thereon. For instance, a graining treatment; a dipping treatment in an aqueous solution of sodium silicate, potassium fluorozirconate, phosphate or so on, or an anodic oxidation treatment can be favorably employed as the surface treatment. Further, an aluminium plate having received a dipping treatment in a sodium silicate aqueous solution after graining, as described in U.S. Patent 2,714,066; and an aluminium plate having received a dipping treatment in an aqueous solution of an alkali metal silicate after an anodic oxidation treatment, as described in Japanese Patent Publication 5125/72 (corresponding to U.S. Patent 3,181,461), can also be employed advantageously. The anodic oxidation treatment for the above-described purpose can be carried out by passing electric current through an aluminium plate dipped in an electrolytic solution made up of aqueous or nonaqueous solutions of inorganic acids such as phosphoric acid, chromic acid, sulfuric acid, boric acid, etc., organic acids such as oxalic acid, sulfamic acid, etc., or the salts thereof independently or in combination of two or more thereof.

In addition, silicate-electrodeposition as described in U.S. Patent 3,658,662 is also effective.

Further, supports obtained by subjecting electrolytically grained supports to anodic oxidation treatments as described above, as disclosed in U.S. Patent 4,087,341; Japanese Patent Publication 27481/71 (corresponding to U.S. Patent 3,891,516) and Japanese Patent Application (OPI) 30503/77, are also useful. (The term "OPI" as used herein refers to a "published unexamined Japanese Patent Application"). Furthermore, an aluminium plate having received, in sequence, a graining treatment, a chemical etching treatment and an anodic oxidation treatment is also preferably used as described in U.S. Patent 3,834,998. These surface treatments are carried out not only for the purpose of rendering the surface of the support hydrophilic but also with various intentions of preventing harmful reactions with the light-sensitive composition to be provided on the support, heightening adhesiveness to the light-sensitive layer, and so on.

Any light-sensitive layer may be coated on the hydrophilic surfaces of the above-described supports as long as it works positively upon patterning, and various compositions for forming such light-sensitive layers have been known. Among those compositions, those which comprise o-quinonediazide compounds are of great advantage.

Especially preferable o-quinonediazide compounds are o-naphthoquinonediazide compounds, and specific examples thereof are described in U.S. Patents 3,046,110; 3,046,111; 3,046,121; 3,046,115; 3,046,118; 3,046,119; 3,046,120; 3,046,121; 3,046,122; 3,046,123; 3,061,430; 3,102,809; 3,106,465; 3,635,709 and 3,647,443: and other various publications. Among those compounds, o-naphthoquinonediazidosulfonic acid esters or o-naphthoquinonediazidocarboxylic acid esters of aromatic hydroxy compounds, and o-naphthoquinonediazidosulfonic acid amides or o-naphthoquinonediazidocarboxylic acid amides of aromatic amino compounds are very advantageously employed. Specific examples of such compounds which can provide especially good results include the compound described in U.S. Patents 3,635,709; which is obtained by an esterification reaction of o-quinonediazidosulfonic acid with a pyrogallol-acetone condensate: compounds prepared by esterifying o-naphthoquinonediazidosulfonic or o-naphthoquinonediazidocarboxylic acid with polyesters having hydroxy groups at their terminals, as described in U.S. Patent 4,028,111: compounds prepared by esterifying o-naphthoquinonediazidosulfonic or o-naphethoquinonediazidocarboxylic acid with homopolymer of p-hydroxystyrene or copolymers of p-hydroxystyrene and other monomers copolymerizable therewith, as described in U.S.Patent 4,139,384: and such amides

- 7 -

as to be obtained by reacting copolymers of p-aminostyrene and other copolymerizable monomers with o-naphthoquinonediazidosulfonic or o-naphthoquinonediazidocarboxylic acid, as described in U.S. Patent 3,759,711.

These o-quinonediazide compounds are preferably used in the form of a mixture with an alkali soluble resin in the formation of the light-sensitive layer, though they can also be used alone. Suitable alkali soluble resins for such a usage include novolak type phenol resins, more specifically phenol-formaldehyde resin, o-cresol-formaldehyde resin, m-cresol-formaldehyde resin and the like. More favorable results can be obtained when the above-described phenol resins are used in combination with condensates of phenol or cresol substituted with alkyl groups having 3 to 8 carbon atoms and formaldehyde, such as t-butylphenol formaldehyde resin, etc., as described in U.S. Patent 4,123,279. A preferable content of an alkali soluble resin in the light-sensitive layer ranges from about 50 wt% to about 85 wt%, particularly from 60 to 80 wt%.

Upon exposure to active rays through an imagewise pattern, the light-sensitive layer comprising an o-quinonediazido compound has immediately generated therein visible contrast, but the thus attained contrast is not always high enough to carry out plate-making operations under a generally used yellow safelight. Therefore, in the embodiment of Process 1 of the present invention, it is desirable to incorporate in advance a print-out material in the light-sensitive layer for the purpose of improvement or enhancement of the visible contrast. A wide variety of materials are known for use as such a print-out material. For instance, pH indicators as described in British Patent 1,041,463; combinations of o-naphthoquinonediazido-4-sulfonyl chloride and dyes as described in U.S. Patent 3,969,118; photochromic compounds as described in Japanese Patent Publication 6413/69; combinations of 2-styryl-5-trihalomethyl-1,3,4-oxadiazoles and dyes as described in U.S. Patent 4,212,970; combinations of vinyl-trihalomethyl-s-triazines and dyes as described in U.S. Patent 3,987,037; and so on can be used herein as a print-out material.

On the other hand, in the embodiment of Process 2 of the present invention, it is desirable to incorporate in advance a certain dye in the light-sensitive layer. Such a dye is employed in order to give a sharp contrast between the image part and the non-image part (surface of support) of a PS plate after development following on imagewise exposure, with suitable examples of alcohol soluble dyes including C.I. 26,105 (Oil Red RR), C.I. 21,260 (Oil Scarlet #308), C.I. 42,595 (Oil Blue), C.I. 52,015 (Methylene Blue), C.I. 42,555 (Crystal Violet) and others. These dyes should be added in an amount sufficient to bring out a decided contrast between the color of the hydrophilic surface of the support, which is laid bare by exposure and subsequent development of the PS plate, and the color of the residual part of the sensitive layer. In general, it is proper to incorporate such a dye in a proportion of about 7 wt% or less to the total weight of the light-sensitive composition.

In addition, a light-sensitive layer comprising an o-quinonediazide compound can optionally contain a plasticizer, a sensitizer and other conventional additives.

Besides the above-described light-sensitive layer comprising an o-quinonediazide compound, a composition comprising a soluble polyamide and an alkali soluble group-containing aromatic azide compound can also be employed as a positive working light-sensitive layer, as described in British Patent 1,520,466.

The positive working light-sensitive compositions as described above are coated on a support in a state of solution in a proper solvent. Suitable examples of the solvent used for dissolving such compositions include glycol ethers such as ethylene glycol monomethyl ether, ethylene glycol monoethyl ether, 2-methoxyethyl acetate, etc.; ketones such as acetone, methyl ethyl ketone, cyclohexanone, etc.; chlorinated hydrocarbons such as ethylene dichloride, etc.; alcohols such as methanol, n-propanol, etc.; and so on.

Preferably the positive working light-sensitive layer is provided on the support at a coverage ranging from about 0.5 to about 7 g/m$^2$, particularly from about 1.5 to 3 g/m$^2$.

The thus obtained positive PS plate is exposed through a transparent original to light rich in active rays, e.g., rays which a carbon arc lamp, a mercury lamp, a metal halide lamp, a xenon lamp, a tungsten lamp or the like gives out.

The print-out image corresponding to the original can be observed in the light-sensitive layer of the positive PS plate which has received imagewise exposure and therefore, if one inspects this print-out image, one can discriminate unnecessary image parts (unexposed parts) from necessary image parts. Accordingly, in Process 1 of the present invention, the thus found unnecessary image parts are irradiated with active rays conducted by an optical fiber.

Optical fibers, and techniques and apparatuses for conducting active rays by means of optical fibers, which can be applied to the present invention are well known and therfore, are not explained in detail herein except for especially favorable embodiments as will be described below.

Bearing the above in mind, in the practice of this invention, one end of a fiber scope for industrial use is connected to the lamp room of a vacuum printing frame, and the other end is connected to an optical fiber pen. The vacuum printing frame used therein can be a universal one fitted with a metal halide lamp as the light source. As the metal halide lamp in the lamp room has such a structure that it is used in the condition that it is always turned on, and imagewise exposure is carried out through opening and shutting of a shutter, it is advantageous that the optical fiber pen is also fitted with a switch for passing on and shutting off the active rays to be conducted from the metal halide lamp to the optical fiber pen, and that the switch is so designed as to be synchronized with an active ray-shielding mechanism either between the lamp room and the fiber scope, or within the optical fiber pen itself. Of course, the light source for the optical fiber and the light source for the vacuum printing frame may be provided separately. It is desirable from the standpoint of facilitating the irradiation of only minute areas that active rays emitted from the tip of the optical fiber be narrowed down, for example, so as to have a luminous flux diameter of about 1 to 5 mm.

In Process 1 of the present invention, a positive PS plate whose unnecessary image parts which are desired to be eliminated have been irradiated with active rays conducted by an optical fiber is then subjected to a development-processing. A developing solution to be employed to advantage can be properly selected from conventional ones depending upon the kind of light-sensitive layer of the PS plate to be processed. For instance, in case of the light-sensitive layer comprising an o-quinonediazide compound, an alkaline aqueous solution, which contains at least one alkali agent such as an inorganic alkali agent (e.g., sodium silicate, potassium silicate, sodium hydroxide, potassium hydroxide, lithium hydroxide, sodium tertiary phosphate, sodium secondary phosphate, potassium tertiary phosphate, potassium secondary phosphate, ammonium tertiary phosphate, ammonium secondary phosphate, sodium metasilicate, sodium hydrogencarbonate, ammonia water, etc.) or an organic alkali agent (e.g., monoethanolamine, di-ethanolamine, etc.), is used. Especially favorable compositions of the alkaline aqueous solution for the above-described purpose are described in detail in U.S. Patent 4,259,434. The development can be carried out in various manners using an automatic developing machine having both a developing unit and a desensitizing gum applying unit or a general automatic developing machine having a washing unit, or according to dish development or development by hand.

On the other hand, in Process 2 of the present invention, an imagewise exposed PS plate is developed with a developing solution as described above, unnecessary parts of the thus formed image on the support are irradiated with active rays conducted by optical fiber and then, the resulting PS plate is developed again with the above-described type of developing solution.

A lithographic printing plate obtained by having been processed according to the above-described processing steps of Process 1 or 2 is coated with desensitizing gum and then, set in a printing machine. Therein, printing is carried out according to a conventional procedure.

The plate-making processes of the present invention can be incorporated into various conventionally known plate-making systems. For instance, in a non-washing plate-making system in which an imagewise exposed PS plate is developed and immediately thereafter, subjected to the coating with desensitizing gum without receiving any washing treatment, a positive PS plate which has received imagewise exposure and irradiation at its unnecessary image parts with active rays conducted by an optical fiber in accordance with the above-described Process 1 is subjected to a development processing, and at once to the coating with desensitizing gum without being subjected to any washing treatment. According to this process, it becomes unnecessary to adopt the plate-making system involving such a deletion step as described in U.S. Patent 4,291,117, which has so far been known as an economical plate-making system and includes the steps of, in sequence, developing the imagewise exposed positive PS plate, dipping the developed plate in an aqueous solution of a surface active agent, (which step is called rinsing), applying a deletion liquid to desired parts, washing the resulting plate with water and coating the plate surface with desensitizing gum. Thus, the processes of the present invention make it needless to include the steps of rinsing, applying a deletion liquid and washing with water, which are necessitated even in the non-washing economical plate-making system. Consequently, this invention provides a great advantage in obtaining the maximum economical efficiency, speediness and low-pollutant waste level which are characteristics of the non-washing plate-making system.

Further, if Process 1 or 2 of the present invention is incorporated into a plate-making system of the type which comprises, in sequence, developing the imagewise exposed positive PS plate, washing the developed plate with water, applying a deletion liquid to desired parts, washing the resulting plate with water and coating the plate surface with desensitizing gum, two steps of applying a deletion liquid and washing with water can be omitted and thereby, the plate-making system of this invention provides great advantages in that a waste disposal load attendant on the plate-making process can be lightened and the overall plate-making processing can be expediently effected.

Furthermore, if Process 2 of the present invention is incorporated into the above-described non-washing economical processing system for plate-making, the resulting system comes to include the steps of developing, rising, irradiating unnecessary image parts with active rays conducted by optical fiber, developing, rinsing and coating with desensitizing gum and consequently, the step of applying a deletion liquid as another composition and washing thereafter with water can be omitted.

In addition to the above-described advantages, the plate-making processes of the present invention have turned out to be particularly effective in eliminating unnecessary image parts which come from dust stuck onto, and fine scratches generated at the transparent original and/or the glass of the vacuum printing frame.

The present invention will now be illustrated in more detail by reference to the following examples. Additionally, in the following examples, all percentages are by weight unless otherwise indicated.

## EXAMPLE 1

The surface of an aluminium plate having a thickness of 0.24 mm was grained using a nylon brush and 400 mesh pumice suspended in water and thereafter, it was thoroughly washed with water. Then, the aluminium plate was dipped in a 10% aqueous solution of sodium hydroxide warmed at 50°C for a period of 20 seconds to effect etching and subsequently, washed with running water (20°C) for 1 minute.

Next, the aluminium plate was subjected to an electrochemical graining treatment by using a 1.5% aqueous solution of nitric acid maintained at a temperature of 20°C and therethrough, by passing the sine wave-shaped alternating current of 10 V with an electricity quantity of 900 coulomb/dm$^2$ for 20 seconds and subsequently, subjected to a desmutting treatment by dipping it for 30 seconds in 20% phosphoric acid heated up to 70°C. After finishing thorough washing, the resulting aluminium plate was soaked in a 15% aqueous solution of sulfuric acid (25°C) and therethrough, direct current of 22 V was passed to form an anodic oxidation coat at a coverage of 3.0 g/m$^2$.

On the thus processed support, a light-sensitive coating solution having the composition described below was coated and dried to provide a light-sensitive layer having a dry coverage of 2.5 g/m$^2$, thus obtaining a positive PS plate.

<u>Light-sensitive Solution:</u>

| | |
|---|---|
| Esterification Product of Naphthoquinone-(1,2)-diazido-(2)-5-sulfonic Acid Chloride with Pyrogallol-Acetone Resin (described in Example 1 of U.S. Patent 3,635,709) | 0.63 g |
| Cresol Novolak Resin | 1.98 g |
| p-t-Butylphenol Resin | 0.05 g |
| Tetrahydrophthalic Anhydride | 0.15 g |
| Thymol Blue | 0.04 g |
| Naphthoquinone-(1,2)-diazido-(2)-4-sulfonic Acid Chloride | 0.03 g |
| Ethylene Dichloride | 18 g |
| 2-Methoxyethyl Acetate | 12 g |

The positive PS plate obtained was brought into close contact with a positive transparent original, and the thus situated PS plate was exposed by using as a light source a metal halide lamp of 3 KW placed at a distance of 1 m for a period of 60 seconds. As a result of the exposure, exposed areas of the light-sensitive layer (non-image part) discolored, and there appeared a print-out image having an image density difference of 0.15 between the image part and the non-image part. Therein, several images to be thought of as unnecessary dust marks were found. Each unnecessary image part was irradiated for 2 seconds with light emitted from one end of an optical glass fiber, which was put over the area desired to be irradiated having an outside diameter of 2 mmø and a length of 1.5 m, the other end of which was fixed to the light source.

- 18 -

The positive PS plate which had received the imagewise exposure and irradiation with active rays at its unnecessary image parts was developed with an aqueous solution of sodium silicate which had a $SiO_2/Na_2O$ ratio of 1.2 by mole and a $SiO_2$ content of 1.5% and immediately thereafter, a desensitizing gum-coat was provided on the resulting plate surface using a printing plate-protecting composition described below.

Preparation of Desensitizing Gum

An aqueous solution A having the composition described below was prepared and thereto, was added a solution B having the composition described below with vigorous stirring to make an emulsion. This emulsion was further emulsified by means of a homogenizer to obtain a desensitizing gum.

Aqueous Solution A;

| | | |
|---|---|---|
| Gum Arabic | 4 | g |
| Dextrin | 16 | g |
| Phosphoric Acid (85%) | 0.05 | g |
| Water | 75 | g |

Solution B;

| | | |
|---|---|---|
| Sodium Laurylsulfosuccinate | 1.0 | g |
| Dibutyl Phthalate | 2.0 | g |
| Polyoxyethylene Nonyl Phenyl Ether | 1.0 | g |
| Sorbitan Tristearate | 1.0 | g |

From the thus obtained lithographic printing plate, the unnecessary image parts which had been present at the time of imagewise exposure were completely removed. Printing was carried out using this printing plate and an offset printing machine according to the conventional order of operations. Thus, 100,000 sheets or more of prints which has good image quality and no stains were obtained.

## EXAMPLE 2

After exposing the positive PS plate prepared in accordance with Example 1 to an imagewise pattern as in Example 1, the detected unnecessary image parts were irradiated by active rays for 3 seconds with light emitted from the one end of an optical glass fiber having an outside diameter of 3 mm∅ and a length of 1 m, the other end of which was connected with the lamp room installed with a mercury lamp of 200 W. On this occasion, the tip of the optical glass fiber is fitted with a shutter in order to shut out the light when the irradiation was not required. The shutter was so designed as to be opened by only when needed. Then, the resulting plate was subjected to development and desensitizing gum coating in the same manner as in Example 1.

From the thus obtained lithographic printing plate, unnecessary image parts had been completely removed similarly to the case of Example 1. Thus, a great number of prints of good quality were obtained.

## EXAMPLE 3

A mechanically grained aluminium plate was dipped for 1 minute in a 2% aqueous solution of sodium hydroxide maintained at 40°C to result in partial corrosion at the surface thereof. After washing with water, it was dipped in a sulfuric acid-chromic acid mixture for 1 minute to reveal the pure aluminium surface. This aluminium plate was soaked in 20% sulfuric acid kept at 30°C and therein, an anodic oxidation treatment was carried out under the condition of a direct current voltage of 1.5 V and a current density of 2 $A/dm^2$ for a period of 2 minutes. The resulting aluminium plate was washed with water and dried. On the thus treated aluminium plate, a light-sensitive solution having the following composition was coated and dried at a dry coverage of 2 $g/m^2$, thus obtaining a positive PS plate.

Light-Sensitive Solution:

| | |
|---|---|
| Esterification product of Naphthoquinone-1,2-diazido(2)-5-sulfonic Acid Chloride with Acetone-Pyrogallol Resin (synthesized using the method described in Example 1 of U.S. Patent 3,635,709) | 0.8 |
| Novolak Type Meta-Para Mixed Cresol-Formaldehyde Resin | 2.2 g |
| Novolak Type p-Octylphenol-Formaldehyde Resin | 0.02 g |
| Phthalic Anhydride | 0.08 g |

- 21 -

| | |
|---|---|
| 2-Trichloromethyl-5-(p-butoxystyryl)-1,3,4-oxadiazole | 0.08 g |
| Crystal Violet p-Toluensulfonate | 0.03 g |
| 2-Methoxyethyl Acetate | 8 g |
| Methyl Ethyl Ketone | 8 g |

This positive PS plate was exposed imagewise using a commercially available vacuum printing frame (light source: metal halide lamp) and then, developed with a water solution of potassium silicate having a $SiO_2/K_2O$ ratio of 1.2 by mole and immediately thereafter, dipped in a rinsing solution having the composition described below, followed by drying.

Rinsing Solution:

| | |
|---|---|
| Water | 1000 g |
| Sodium Salt of Lauryl Alcohol Sulfuric Acid Ester | 2 g |
| Sodium Salt of Di(2-ethylhexyl)sulfosuccinic Acid Ester | 40 g |

In the thus obtained lithographic printing plate, several unnecessary image parts were found. Each of these unnecessary image parts was irradiated for 2 seconds with light emitted from one end of an optical fiber having an outside diameter of 3 mmø and a length of 1.5 m, the other end of which was connected to the lamp room of the vacuum printing frame. On this occasion, the tip of the optical fiber was fitted with a shutter which was do designed as to be opened only when needed. Next, the resulting PS plate was developed again with the above-described developing solution and then, treated at once with the above-described rinsing solution.

From the lithographic printing plate obtained by having received the above-described plate-making processing, the unnecessary image parts had been clearly eliminated. After desensitizing gum-coating, the lithographic plate was subjected to the conventional printing operations. Thus, 70,000 sheets or more of beautiful prints were obtained.

0123153

WHAT IS CLAIMED IS:

1.  A process for making a printing plate which comprises the steps of, in sequence, imagewise exposing a light-sensitive layer of a positive working presensitized plate to active rays through a positive transparency, irradiating unnecessary unexposed parts of the light-sensitive layer with active rays conducted by an optical fiber, and developing the thus optically exposed presensitized plate.

2.  A process for making a printing plate which comprises the steps of, in sequence, imagewise exposing a light-sensitive layer of a positive working presensitized plate to active rays through a positive transparency, developing the photoexposed presensitized plate in a first development step, irradiating unnecessary image parts with active rays conducted by an optical fiber, and developing the resulting plate again.

3.  The process of Claim 1 wherein the light-sensitive layer includes a print-out material to improve visible contrast between exposed and unexposed parts.

4.  The process of Claim 2 wherein the light-sensitive layer includes a dye to sharpen contrast between image and non-image parts after the first development step.

- 24 -

5.     The process of any of Claims 1-4 wherein the presensitized plate comprises a light-sensitive composition comprising an o-quinonediazine compound coated as a layer on a hydrophilic surface of a support.

6.     The process of Claim 5 wherein said support comprises an aluminum layer.

7.     The process of Claim 5 wherein said support comprises an aluminum alloy layer.

8.     The process of Claim 3 wherein said print-out material is a pH indicator, a combination of o-naphtha-quinone-diazido-4-sulfonyl chloride and a dye, a photochromic compound, a combination of a 2-styryl-5-trihalomethyl-1,3,4-oxadiazole and a dye, or a combination of a vinyl-trihalomethyl-s-triazine and a dye.

9.     The process of Claim 4 wherein said dye is an alcohol soluble dye.

10.     The process of Claim 5 wherein said light-sensitive layer includes an alkali soluble resin admixed with said o-quinonediazide compound.